# EUROPEAN PATENT SPECIFICATION

(11) **EP 2 410 584 B1**
(45) Date of publication and mention of the grant of the patent: **14.09.2016**
(21) Application number: 09838673.3
(22) Date of filing: 09.12.2009
(51) Int. Cl.: H01L 35/32, H01L 35/34

(54) **METHOD FOR MANUFACTURING THERMOELECTRIC CELL**
VERFAHREN ZUR HERSTELLUNG THERMOELEKTRISCHER ZELLE
PROCÉDÉ DE PRODUCTION D'UNE CELLULE THERMOÉLECTRIQUE

(30) Priority: 20.01.2009 CN 200910105173
(43) Date of publication of application: 25.01.2012
(73) Proprietor: Shenzhen Caihuang Enterprise & Development Co., Ltd, Shenzhen, Guangdong 518109 (CN)
(72) Inventor: FAN, Ping, Shenzhen Guangdong 518060 (CN); ZHANG, Dongping, Shenzhen Guangdong 518060 (CN); ZHENG, Zhuanghao, Shenzhen Guangdong 518060 (CN); LIANG, Guangxing, Shenzhen Guangdong 518060 (CN)
(74) Representative: Bosch, Matthias
(86) International application number: PCT/CN2009/075422
(87) International publication number: WO 2010/083706

(56) References cited:
- EP-A1- 1 780 811
- CN-A- 101 483 218
- JP-A- H0 735 618
- JP-A- H05 327 033
- US-A1- 2004 139 998
- US-A1- 2007 144 573

## Description

### FIELD OF THE INVENTION

This invention relates to thermo-electric technology, and more particularly to a thermoelectric cell and a fabrication method thereof.

### BACKGROUND OF THE INVENTION

The thermoelectric cell is a kind of cell made on the basis of temperature differences, and the heat energy is transformed into electric energy due to Seebeck effect. The working principle of thermoelectric cell is that connecting one end of two different metals or two different types of thermo-electric conversion materials P-type and N-type semiconductors, placing this end in high temperature condition, and placing the other end in low temperature condition. Compared with the other end, the end in high temperature condition has better thermal activation and higher density of electrons and holes, and the electrons and holes spread to the end in low temperature condition, such that an electric potential difference is formed in the end in low temperature condition. Combining a number of this kind of thermo-electric conversion materials P-type and N-type semiconductors to form a module supplying adequate voltage, this module becomes a thermoelectric cell.

The thermoelectric cell is a kind of clean, noiseless energy without discharging any hazardous substance, having high reliability and long useful time, and supplying long, safe and continuous table electricity output. Presently the thermoelectric cell is made by cutting and welding the thermo-electric materials. There are two types of fabrication methods. In the first method, a photosensitive resist is painted on the same chip, then P-type and N-type areas are formed through double photo etching respectively, and finally P-type and N-type thermo-electric materials are deposited in the P-type and N-type area respectively. This method is difficult for application, especially for the procedure of combining thermo-electric units in which the chip is required to be stripped from the deposited thermo-electric units. In the second method, P-type and N-type thermo-electric unit chips are separately manufactured. In the fabrication of micro thin-film thermoelectric cell, the conducting layer connecting P-type and N-type thermo-electric units can be manufactured assuming that the chip is not stripped from the deposited thermo-electric units. This method has complicated procedures. The thin-film of the thermoelectric cell is merely limited to single thin-film connecting P-type and N-type thermo-electric units, and then the performance is limited.

Technova KK has filed a Japanese application (JP H0735618A) in which a thermoelectric transducer is disclosed. The thermoelectric transducer comprises a P-type thermoelectric conversion material 3, an N-type thermoelectric conversion material 4 and substrate 1. The P-type thermoelectric conversion material 3 is formed on one side of the substrate 1, and the N-type thermoelectric conversion material 4 is formed on the other side of the substrate 1. A PN direct junction 5 is formed with a part of the P-type thermoelectric conversion material 3 overlapping a part of the N-type thermoelectric conversion material 4.

Hitachi LTD has filed a Japanese application (JP H05 327033A) which discloses a thermoelectric conversion element, comprising a P-type semiconductor 10 and an N-type semiconductor 15. These two semiconductors are formed on one and the other surface of a substrate 1.

However, both applications recite complicated fabrication processes and the obtained thermo-electric cell has a relatively poor performance. So a thin-film thermo-electric cell and fabrication method thereof for improving the performance and simplifying the fabrication processes is still needed.

### SUMMARY OF THE INVENTION

To solve the above-mentioned problem, this invention provides a thin-film thermoelectric cell and fabrication method thereof for improving the performance and simplifying the fabrication processes.

The technical solutions of the present invention are as follows.

A method for fabricating a thermo-electric cell, comprises steps as follows:
selecting Sb, Bi and Te as target materials, wherein Sb and Bi targets are set in direct current target sites respectively, and then Te target is set in a radio frequency target site;
putting an insulating substrate in a fixture in a deposition chamber; wherein the fixture is configured to turn over the insulating substrate such that such that films are deposited on both sides of the insulating substrate ;
exposing one side of the insulating substrate , sheltering all the other sides; aslant setting the insulating substrate at a certain angle for deposition of Sb, Bi and Te films on an exposed side of the insulating substrate ;
depositing a P-type thermo-electric thin-film layer with a thickness of 1 nm to 10µm on one side of the insulating substrate by depositing Sb and Te films respectively on one side of the insulating substrate using a direct current sputtering and a radio frequency sputtering respectively and then implementing a subsequent heat treating;
depositing a N-type thermo-electric thin-film layer with a thickness of 1 nm to 10µm on the other side of the insulating substrate by adjusting the target materials and turning over the substrate insulating substrate , depositing Bi and Te films respectively on the other side of the insulating substrate using a direct current sputtering and a radio frequency sputtering respectively and then implementing a subsequent heat treating;
connecting the P-type thermo-electric thin-film layer and the N-type thermo-electric thin-film layer on the exposed side of the insulating substrate ;
extracting electrodes from the P-type thermo-electric thin-film layer and the N-type thermo-electric thin-film layer respectively to form a main structure of the thermo-electric cell.

In the method for fabricating a thermo-electric cell according to the present application, a thickness range of the insulating substrate is 0.1mm-100mm.

In the method for fabricating a thermo-electric cell according to the present application, a shape of the insulating substrate is regular rectangle.

In the method for fabricating a thermo-electric cell according to the present application, a shape of the insulating substrate is plane or curved surface.

For the thermoelectric cell and fabrication method of this invention, a P-type thermo-electric thin-film layer and a N-type thermo-electric thin-film layer are respectively deposited on two sides of a insulating substrate. During the deposition, the P-type thermo-electric thin-film layer and the N-type thermo-electric thin-film layer are deposited and connected on the same exposed side of the insulating substrate, and then a PN junction is formed. This method makes the fabrication simplified without special process for connecting the P-type thermo-electric thin-film layer and the N-type thermo-electric thin-film layer. Due to the features of thin-film thermo-electric material, the performance of thermoelectric cell is greatly improved. During the deposition, the P-type thermo-electric thin-film layer and the N-type thermo-electric thin-film layer are deposited and connected on the exposed side of the insulating substrate, so welding is not required in this heating surface side, and the performance of thermoelectric cell fabricated in heating surface working temperature is accordingly greatly improved.

### BRIEF DESCRIPTION OF THE DRAWINGS

FIG. 1 is a cross-sectional diagram of the fabrication process of the thermoelectric cell in a first embodiment of the invention.
FIGS. 2a and 2b are schematic diagrams of the fabrication process of the thermoelectric cell in the first embodiment of the invention.
FIG. 3 is a cross-sectional diagram of the fabrication process of the thermoelectric cell in a second embodiment of the invention.
FIGS. 4a and 4b the schematic diagrams of the fabrication process of the thermoelectric cell in the second embodiment of the invention.

### DETAILED DESCRIPTION OF ILLUSTRATIVE EMBODIMENTS

In the embodiment, the present invention provides a thin-film thermoelectric cell and a fabrication method thereof. To make the technical solutions of the present invention more comprehensible, the present invention is described in detail with reference to the accompanying drawings and embodiments as follows.

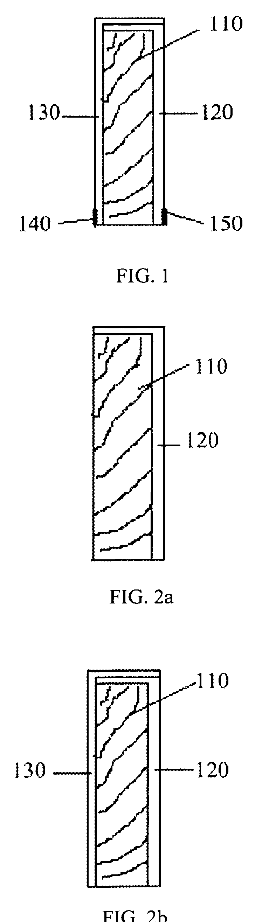

FIG. 1 is a cross-sectional diagram of the fabrication process of the thermoelectric cell in a first embodiment of the invention. Wherein the thermoelectric cell comprises an insulating substrate 110, a P-type thermo-electric thin-film layer 120 deposited on one side of said insulating substrate 110, and a N-type thermo-electric thin-film layer 130 deposited on the other side of said insulating substrate 110. Two electrodes 140 and 150 are respectively extracted from said P-type thermo-electric thin-film layer 120 and N-type thermo-electric thin-film layer 130. The structure shown in FIG. 2a is achieved by depositing a P-type thermo-electric thin-film layer 120 on one side of said insulating substrate 110, and the structure shown in FIG. 2b is further achieved by depositing a N-type thermo-electric thin-film layer 130 on the other side of said insulating substrate 110. Electrodes 140 and 150 are extracted respectively from said P-type thermo-electric thin-film layer 120 and N-type thermo-electric thin-film layer 130 shown in FIG. 2b, at last, the thermoelectric cell is formed. Wherein said P-type thermo-electric thin-film layer 120 and N-type thermo-electric thin-film layer 130 are entirely overlap connected on one side of said insulating substrate 110.

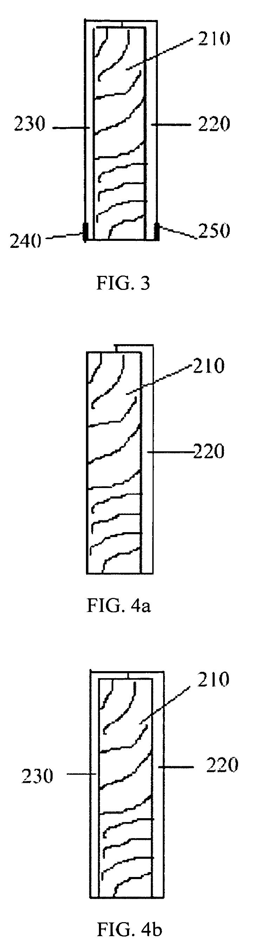

FIG. 3 is a cross-sectional diagram of the fabrication process of the thermoelectric cell in a second embodiment of the invention. Wherein the thermoelectric cell comprises an insulating substrate 210, a P-type thermo-electric thin-film layer 220 deposited on one side of said insulating substrate 210, and a N-type thermo-electric thin-film layer 230 deposited on the other side of said insulating substrate 210. Two electrodes 240 and 250 are respectively extracted from said P-type thermo-electric thin-film layer 220 and N-type thermo-electric thin-film layer 230. The structure shown in FIG. 4a is achieved by depositing a P-type thermo-electric thin-film layer 220 on one side of said insulating substrate 210, and the structure shown in FIG. 4b is further achieved by depositing a N-type thermo-electric thin-film layer 230 on the other side of said insulating substrate 210. Said P-type thermo-electric thin-film layer 220 and N-type thermo-electric thin-film layer 230 are deposited and connected together on the exposed side of said insulating substrate 210. Electrodes 240 and 250 are extracted respectively from said P-type thermo-electric thin-film layer 220 and N-type thermo-electric thin-film layer 230 shown in FIG. 4b, at last, the thermoelectric cell is formed.

The materials applied in the thermoelectric cell in the above-mentioned embodiments can be metal and semiconductor. Said P-type thermo-electric material and N-type thermo-electric can be two different metal materials, and the thermoelectric cell can be formed by depositing two different metal thin-film layers. The insulating substrates can be regular shapes, such as a rectangle or a square, or any irregular shapes.

The shape of exposed side of the insulating substrates can be plane or curved surface.

For the above mentioned thermoelectric cell, its fabrication processes are simplified, the fabrication cost is reduced and the performance is highly improved.

With third and fourth embodiments, the fabrication processes of thermoelectric cell are described in details as below.

### The third embodiment

The device for fabricating the thermoelectric cell in the third embodiment is a three-target magnetron sputtering coater. Sb, Bi and Te are selected as target materials with a purity of 99.99%. Sb and Bi targets are set in the direct current target sites respectively, and then Te target is set in the radio frequency target site. Ultrasonic wash with organic solvent is conducted on the substrate of common soda lime glass, and it is put in a fixture in the deposition room. The fixture may be configured to turn over the substrate such that films may be deposited on both sides of the substrate. The insulating substrate 110 may be configured with one side exposed and with other sides sheltered. The substrate 110 may be slant set at a certain angle such that Sb, Bi and Te films may be deposited respectively on the exposed side of the substrate 110. In the room temperature, during the deposition, Sb and Te films may be deposited respectively on one side of the insulating substrate 110 using direct current sputtering and radio frequency sputtering respectively. After subsequent heat treating, a P-type thermo-electric Sb₂Te₃ thin-film layer 120 with a thickness of 700nm is formed, as shown in FIG. 2a. Then by adjusting target materials and turning over the substrate, Bi and Te films may be deposited respectively on the other side of the insulating substrate 110 using direct current sputtering and radio frequency sputtering respectively. After subsequent heat treating, a N-type thermo-electric Bi₂Te₃ thin-film layer 130 with a thickness of 700nm is formed, as shown in FIG. 2b. After the insulating substrate 110 with one side deposited with Sb and Te films and the other side deposited with Bi and Te films, annealing at temperature 200°C for some time is performed. During the deposition, the background vacuum degree is 2.8x 10⁻⁴ *Pa,* the working vacuum degree is 6.1 x 10⁻¹ *Pa,* and the working gas is Ar gas with a purity of 99.99% and with a rate of flow of 50sccm.

After the deposition of Sb₂Te₃ layer 120 on one side of the insulating substrate 110 and the deposition of Bi₂Te₃ layer 130 on the other side, the electrodes are extracted from layer 120 and layer 130 respectively to form the main structure of the thermoelectric cell shown in FIG. 1 and FIG. 3.

Then the thin-film thermoelectric cell is made by scribing, racking, packaging and related subsequent procedures.

Several methods can be applied to make the P-type and N-type thermo-electric thin-film layers, such as vacuum evaporation, Molecule Beam Epitaxy (MBE), magnetron sputtering, sputtering deposition, Laser Deposition, electrochemical atomic layer epitaxy (ECALE), metal-organic chemical vapor deposition (MOCVD), and successive ionic layer adsorption and reaction (SILAR).

During the above-said fabrication process, the deposition of the P-type thermo-electric thin-film layer 120 can be carried out before or after the deposition of the N-type thermo-electric thin-film layer 130.

### The fourth embodiment

The device for fabricating the thermoelectric cell in the fourth embodiment is an ultrahigh vacuum sputtering deposition coater. Selecting targets of Seebeck index P-type metal Sb and N-type Bi, the purity of the target is 99.99%. Sb and Bi targets are set in the rotatable target sites respectively, and then Te target is set in the radio frequency target position. Ultrasonic wash with organic solvent is conducted on the substrate of common soda lime glass, and it is put in a fixture in the deposition room. The fixture may be configured to turn over the substrate such that films may be deposited on both sides of the substrate. The insulating substrate 110 may be configured with one side exposed and with other sides sheltered. The substrate 110 may be slant set at a certain angle such that Sb and Bi laminated films may be deposited on the exposed side of the substrate 110. In the room temperature, during the deposition in FIG. 2, deposition of Sb thin-film layer 120 with a thickness of 300 nm is conducted on one side of the insulating substrate 110 using magnetron sputtering. Then by adjusting target materials and turning over the substrate, deposition of Bi thin-film layer 130 with a thickness of 300 nm is conducted on the other side of the insulating substrate 110, as shown in FIG. 2b. During the deposition, the background vacuum degree is 4.5×10⁻⁴ *Pa*, the working vacuum degree is 4.1×10⁻² *Pa*, and the working gas is Ar gas with a purity of 99.99% and with a rate of flow of 4 sccm. The parameters of magnetron deposition are as follows: the plate voltage is 1 KV, the anode voltage is 75 V, the accelerating voltage is 220 V, the cathode voltage is 7 V, the cathode current is 11 A, and the beam current is 14 mA.

After the deposition of Sb layer 120 on one side of the insulating substrate 110 and the deposition of Bi layer 130 on the other side, electrodes 140 and 150 are extracted from Sb layer 120 and Bi layer 130 respectively to form the main structure of the thermoelectric cell shown in FIG. 1 and FIG. 3.

Then the thin-film thermoelectric cell is made by scribing, racking, packaging and related subsequent procedures.

During the depositions in the other embodiments, the exposed areas of P-type and N-type materials on the insulating substrate can be partly overlapped. The thickness of said substrate ranges from 0.1 mm to 100 mm, and may be thicker or thinner.

The methods for fabricating the above mentioned thermoelectric cell make the fabrication process simplified and cost-effective, and greatly improve the performance of the thermoelectric cell. The single thermoelectric cell can be connected in series in large numbers, and that can produce enough output voltage in condition of low temperature difference.

Thermo-electric phenomenon is reversible, and the semiconductor thermo-electric generation and refrigeration can be reversible. For a single PN junction, if the temperature difference is used for electricity generation, then the electricity can be used for refrigeration in the other end. Thus, the main thin-film thermoelectric cell structure can be the main structure of the thin-film thermo-electric cooler.

## Claims

1. A method for fabricating a thermo-electric cell, comprising steps as follows:
selecting Sb, Bi and Te as target materials, wherein Sb and Bi targets are set in direct current target sites respectively, and then Te target is set in a radio frequency target site;
putting an insulating substrate (110) in a fixture in a deposition chamber; wherein the fixture is configured to turn over the insulating substrate (110) such that films are deposited on both sides of the insulating substrate (110);
exposing one side of the insulating substrate (110), sheltering all the other sides; aslant setting the insulating substrate (110) at a certain angle for deposition of Sb, Bi and Te films on an exposed side of the insulating substrate (110);
depositing a P-type thermo-electric thin-film layer (120) with a thickness of 1 nm to 10µm on one side of the insulating substrate (110) by depositing Sb and Te films respectively on one side of the insulating substrate (110) using a direct current sputtering and a radio frequency sputtering respectively and then implementing a subsequent heat treating;
depositing a N-type thermo-electric thin-film layer (130) with a thickness of 1 nm to 10µm on the other side of the insulating substrate (110) by adjusting the target materials and turning over the substrate insulating substrate (110), depositing Bi and Te films respectively on the other side of the insulating substrate (110) using a direct current sputtering and a radio frequency sputtering respectively and then implementing a subsequent heat treating;
connecting the P-type thermo-electric thin-film layer (120) and the N-type thermo-electric thin-film layer (130) on the exposed side of the insulating substrate (110);
extracting electrodes (140, 150) from the P-type thermo-electric thin-film layer (120) and the N-type thermo-electric thin-film layer (130) respectively to form a main structure of the thermo-electric cell.

2. The method for fabricating a thermo-electric cell according to claim 1, wherein, a thickness range of the insulating substrate (110) is 0.1mm-100mm.

3. The method for fabricating a thermo-electric cell according to claim 1, wherein, a shape of the insulating substrate (110) is regular rectangle.

4. The method for fabricating a thermo-electric cell according to claim 1, wherein, a shape of the insulating substrate (110) is plane or curved surface.

## Patentansprüche

1. Verfahren zum Herstellen einer thermoelektrischen Zelle, das die folgenden Schritte umfasst:
Auswählen von Sb, Bi und Te als Zielmaterialien, wobei Sb und Bi jeweils als Ziele in Gleichspannungs-Zielsequenzen gesetzt werden und Te dann als Ziel in einer Hochfrequenz-Zielsequenz gesetzt wird;
Einbringen eines Isoliersubstrats (110) in eine Vorrichtung in einer Abscheidungskammer; wobei die Vorrichtung dazu konfiguriert ist, das Isoliersubstrat (110) so umzudrehen, dass Filme auf beiden Seiten des Isoliersubstrats (110) abgeschieden werden;
Freilegen einer Seite des Isoliersubstrats (110), und Abschirmen aller anderen Seiten;
Schrägstellen des Isoliersubstrats (110) in einem bestimmten Winkel zur Abscheidung von Sb, Bi und Te Filmen auf einer freiliegenden Seite des Isoliersubstrats (110);
Abscheiden einer thermoelektrischen Dünnfilmschicht vom P-Typ (120) mit einer Stärke von 1 nm bis 10 µm auf einer Seite des Isoliersubstrats (110) durch Abscheiden von Sb bzw. Te Filmen auf einer Seite des Isoliersubstrats (110) unter Verwendung von Gleichspannungssputtern bzw. Hochfrequenzsputtern und dann Implementieren einer folgenden Wärmebehandlung;
Abscheiden einer thermoelektrischen Dünnfilmschicht vom N-Typ (130) mit einer Stärke von 1 nm bis 10 µm auf der anderen Seite des Isoliersubstrats (110) durch Anpassen der Zielmaterialien und Umdrehen des Isoliersubstrats (100), Abscheiden von Bi bzw. Te Filmen auf der anderen Seite des Isoliersubstrats (100) unter Verwendung von Gleichspannungssputtern bzw. Hochfrequenzsputtern und dann Implementieren einer folgenden Wärmebehandlung;
Verbinden der thermoelektrischen Dünnfilmschicht vom P-Typ (120) und der thermoelektrischen Dünnfilmschicht vom N-Typ (130) auf der freiliegenden Seite des Isoliersubstrats (110);
Extrahieren von Elektroden (140, 150) aus der thermoelektrischen Dünnfilmschicht vom P-Typ (120) bzw. der thermoelektrischen Dünnfilmschicht vom N-Typ (130), um eine Hauptstruktur der thermoelektrischen Zelle zu bilden.

2. Verfahren zum Herstellen einer thermoelektrischen Zelle nach Anspruch 1, wobei der Stärkebereich des Isoliersubstrats (110) von 0,1 mm bis 100 mm reicht.

3. Verfahren zum Herstellen einer thermoelektrischen Zelle nach Anspruch 1, wobei die Form des Isoliersubstrats (110) ein gleichmäßiges Rechteck ist.

4. Verfahren zum Herstellen einer thermoelektrischen Zelle nach Anspruch 1, wobei die Form des Isoliersubstrats (110) eine ebene oder eine gebogene Oberfläche ist.

## Revendications

1. Procédé de fabrication d'une cellule thermoélectrique, comprenant les étapes comme suit :
sélectionner le Sb, le Bi et le Te comme matériaux cibles, dans lequel les cibles Sb et Bi sont situées dans des sites cibles à courant continu respectivement, puis la cible Te est située dans un site cible de radiofréquence ;
placer un substrat isolant (110) dans un dispositif de fixation dans une chambre de dépôt ; dans lequel le dispositif de fixation est conçu pour tourner sur le substrat isolant (110) de telle sorte que les films sont déposés sur les deux côtés du substrat isolant (110) ;
exposer un côté du substrat isolant (110), à l'abri de tous les autres côtés ; placer en biais le substrat isolant (110) à un certain angle pour le dépôt de films de Sb, de Bi et de Te sur un côté exposé du substrat isolant (110) ;
déposer une couche de film mince thermoélectrique de type P (120) ayant une épaisseur de 1 nm à 10 µm sur un côté du substrat isolant (110) par dépôt de films de Sb et de Te, respectivement, sur un côté du substrat isolant (110) au moyen d'une pulvérisation cathodique à courant continu et d'une pulvérisation cathodique à radiofréquence, respectivement, et ensuite mettre en oeuvre un traitement ultérieur par la chaleur ;
déposer une couche de type film mince thermoélectrique de type N (130) ayant une épaisseur de 1 nm à 10 µm sur l'autre côté du substrat isolant (110) par ajustement des matériaux cibles et retournement du substrat isolant (110), déposer des films de Bi et de Te, respectivement, sur l'autre côté du substrat isolant (110) au moyen d'une pulvérisation cathodique à courant continu et d'une pulvérisation cathodique à radiofréquence, respectivement, et ensuite mettre en oeuvre un traitement ultérieur par la chaleur ;
relier la couche de film mince thermoélectrique de type P (120) et la couche de film mince thermoélectrique de type N (130) sur le côté exposé du substrat isolant (110) ;
extraire des électrodes (140, 150) de la couche de film mince thermoélectrique de type P (120) et la couche de film mince thermoélectrique de type N (130), respectivement, pour former une structure principale de la cellule thermoélectrique.

2. Procédé de fabrication d'une cellule thermoélectrique selon la revendication 1, dans lequel, une plage d'épaisseur du substrat isolant (110) est de 0,1 mm à 100 mm.

3. Procédé de fabrication d'une cellule thermoélectrique selon la revendication 1, dans lequel, une forme du substrat isolant (110) est un rectangle régulier.

4. Procédé de fabrication d'une cellule thermoélectrique selon la revendication 1, dans lequel une forme du substrat (110) isolant est une surface plane ou incurvée.
